# EUROPEAN PATENT APPLICATION

(11) **EP 4 766 113 A1**
(43) Date of publication of application: **24.06.2026**
(21) Application number: 25221578.5
(22) Date of filing: 08.12.2025
(51) Int. Cl.: H10K 50/828

(54) **DISPLAY PANEL, MANUFACTURING METHOD OF THE DISPLAY PANEL AND ELECTRONIC DEVICE COMPRISING THE DISPLAY PANEL**

(30) Priority: 19.12.2024 KR 20240190805
(71) Applicant: Samsung Display Co., Ltd., Yongin-si, Gyeonggi-do 17113 (KR)
(72) Inventor: SON, Ji-Hee, 17113 Yongin-si (KR); KIM, Hwi, 17113 Yongin-si (KR); LEE, Joongu, 17113 Yongin-si (KR)
(74) Representative: Marks & Clerk LLP

(57) **Abstract**

A display panel includes a light-emitting diode. The light-emitting diode includes a first driving electrode, a light-emitting layer and a second driving electrode. The light-emitting layer is disposed on the first driving electrode. The second driving electrode is disposed on the light-emitting layer. The second driving electrode includes a first conductive layer and a second conductive layer. The first conductive layer has a first thickness. The second conductive layer contacts the first conductive layer. The second conductive layer includes silver. The second conductive layer is disposed on the first conductive layer. The second conductive layer has a second thickness greater than or equal to 7 times of the first thickness and smaller than or equal to 15 times of the first thickness.

## Description

### BACKGROUND

### 1. Technical Field

The present disclosure relates to a display device, a manufacturing method for the display device, and an electronic device including the display device. Particularly, the present disclosure relates to a display panel having improved light-emitting efficiency of a light-emitting diode by having an improved film density of a second driving electrode, a manufacturing method of the display panel, and an electronic device including the display panel.

### 2. Description of the Related Art

An electronic device may include a display panel. The display panel may include a plurality of light-emitting diodes. In addition, the plurality of light-emitting didoes may each include a first driving electrode, a light-emitting layer, and a second driving electrode. In addition, the second driving electrode may affect light-emitting characteristics of a display panel.

For example, visibility characteristics of a display panel, such as luminance and light-emitting efficiency, may be improved, for example, according to a sheet resistance, light transmittivity, light reflectivity and a film density of a second driving electrode.

### SUMMARY

The present disclosure aims to solve the above task and relates to a display panel having improved light-emitting efficiency of a light-emitting diode by having an improved film density of a second driving electrode, a manufacturing method for the display panel and the electronic device including the display panel.

A display panel according to one embodiment of the disclosure includes a light-emitting diode. The light-emitting diode includes a first driving electrode, a light-emitting layer, and a second driving electrode. The light-emitting layer is disposed on the first driving electrode. The second driving electrode is disposed on the light-emitting layer. The second driving electrode includes a first conductive layer and a second conductive layer. The first conductive layer has a first thickness. The second conductive layer contacts the first conductive layer. The second conductive layer includes silver (Ag). The second conductive layer is disposed on the first conductive layer. The second conductive layer has a second thickness greater than or equal to 7 times of the first thickness and smaller than or equal to 15 times of the first thickness.

In one embodiment of the present disclosure, the first thickness may be greater than or equal to 5 Ångström and smaller than or equal to 20 Ångström, and the second thickness may be greater than or equal to 35 Ångström and smaller than or equal to 300 Ångström.

In one embodiment of the present disclosure, in the second driving electrode, a crystal plane with Miller Index of (111) may have a size greater than or equal to 54 Ångström and smaller than or equal to 64 Ångström.

In one embodiment of the present disclosure, in the second driving electrode, an interplanar distance among a plurality of crystal planes with Miller Index of (111) may be greater than or equal to 2.345 Ångström and smaller than or equal to 2.349 Ångström.

In one embodiment of the present disclosure, the first conductive layer may include at least one of ytterbium (Yb), nickel (Ni), copper (Cu), aluminium (Al), gold (Au) and lithium fluoride (LiF). The second conductive layer may further include at least one of magnesium (Mg), ytterbium (Yb), and copper (Cu).

In one embodiment of the present disclosure, the second driving electrode may further include a third conductive layer. The third conductive layer may contact the second conductive layer. The third conductive layer may be disposed on the second conductive layer. The third conductive layer may have a third thickness smaller than the second thickness.

In one embodiment of the present disclosure, the first thickness may be greater than or equal to 5 Ångström and smaller than or equal to 20 Ångström. The second thickness may be greater than or equal to 35 Ångström and smaller than or equal to 300 Ångström. The third thickness may be greater than or equal to 5 Ångström and smaller than or equal to 20 Ångström.

In one embodiment of the present disclosure, in the second driving electrode, a crystal plane with Miller Index of (111) may have a size greater than or equal to 56.5 Ångström and smaller than or equal to 67.5 Ångström.

In one embodiment of the present disclosure, in the second driving electrode, an interplanar distance among a plurality of crystal planes with Miller Index of (111) may be greater than or equal to 2.3500 Ångström and smaller than or equal to 2.3520 Ångström.

In one embodiment, the first conductive layer may include at least one of ytterbium (Yb), nickel (Ni), copper (Cu), aluminium (Al), gold (Au) and lithium fluoride (LiF). The second conductive layer may further include at least one of magnesium (Mg), ytterbium (Yb), and copper (Cu). The third conductive layer may include at least one of ytterbium (Yb), nickel (Ni), copper (Cu), aluminium (Al), gold (Au) and lithium fluoride (LiF).

In one embodiment of the present disclosure, the second driving electrode may have a face-centered cubic lattice crystal structure. The crystal structure may have a crystal plane with Miller Index of (111) defined as a dense plane. A crystal plane with Miller Index of (220) may be defined as a non-dense plane. A value obtained by dividing an area of the dense plane by an area of the non-dense plane may be greater than or equal to 5.4 and smaller than or equal to 6.4.

In one embodiment of the present disclosure, the crystal structure may be a face-centered cubic lattice crystal structure, the dense plane may be a crystal plane with Miller Index of (111), and the non-dense plane may be a crystal plane with Miller Index of (220).

In one embodiment of the present disclosure, before disposing the second driving electrode, the light-emitting layer may be heated to a temperature higher than or equal to 70 °C and lower than or equal to 90 °C for 20 minutes or more and 30 minutes or less.

A manufacturing method for a display panel according to one embodiment of the present disclosure includes preparing, heating, and forming a first conductive layer, and forming a second conductive layer. In the step of preparing, a first driving electrode and a light-emitting layer disposed on the first driving electrode are prepared. In the step of heating, the first driving electrode and the light-emitting layer are heated. In the step of forming the first conductive layer, the first conductive layer is formed on the heated light-emitting layer. In the step of forming the second conductive layer, the second conductive layer is formed directly on the first conductive layer and comprises silver (Ag).

In one embodiment of the present disclosure, in the step of heating, the first driving electrode and the light-emitting layer may be heated to a temperature higher than or equal to 70 °C and lower than or equal to 90 °C .

In one embodiment of the present disclosure, in the step of heating, the first driving electrode and the light-emitting layer may be heated for 20 minutes or more and 30 minutes or less.

In one embodiment of the present disclosure, in the step of heating, the first driving electrode and the light-emitting layer may be heated under a vacuum environment.

In one embodiment of the present disclosure, in the step of forming the first conductivity, a temperature of the light-emitting layer may be higher than or equal to 60 °C and lower than or equal to 90 °C .

In one embodiment of the present disclosure, the manufacturing method for the display panel may further include forming a third conductive layer. In the step of forming the third conductive layer, the third conductive layer may be formed directly on the second conductive layer.

In one embodiment of the present disclosure, in the step of forming the second conductive layer, a first deposition material and a second deposition material may be simultaneously deposited. The first deposition material may be silver (Ag). The second deposition material may include at least one of magnesium (Mg), ytterbium (Yb), and copper (Cu).

An electronic device according to one embodiment of the present disclosure includes a display panel including a light-emitting diode. The light-emitting diode includes a first driving electrode, a light-emitting layer and a second driving electrode. The light-emitting layer is disposed on the first driving electrode. The second driving electrode is disposed on the light-emitting layer. The second driving electrode includes a first conductive layer and a second conductive layer. The first conductive layer has a first thickness. The second conductive layer contacts the first conductive layer. The second conductive layer includes silver (Ag). The second conductive layer is disposed on the first conductive layer. The second conductive layer has a second thickness greater than or equal to 7 times of the first thickness and smaller than or equal to 15 times of the first thickness.

At least some of the above and other features of the invention are set out in the claims.

According to one embodiment of the present disclosure, a second driving electrode may be formed on a heated light-emitting portion so that a film density of the second driving electrode can be improved (e.g., increased). Accordingly, it becomes possible to provide a display panel having improved light-emitting efficiency, a manufacturing method of the display panel, and an electronic device including the display panel.

### BRIEF DESCRIPTION OF THE DRAWINGS

These and/or other features will become apparent and more readily appreciated from the following description of the embodiments, taken in conjunction with the accompanying drawings in which:
FIG. 1 is an illustration of a display panel according to one embodiment of the present disclosure;
FIGS. 2A through 2D are cross-sectional views of a display device according to one embodiment of the present disclosure;
FIG. 3 is a plan view of a display panel according to one embodiment of the present disclosure;
FIG. 4 illustrates an equivalent circuit of a pixel according to one embodiment of the present disclosure;
FIG. 5 is an illustration of light-emission control signals and scan signals applied to the pixel shown in FIG. 4;
FIG. 6 is a cross-sectional view of a base member and a display panel according to one embodiment of the present disclosure;
FIG. 7 is an illustration of a cross-section of a light-emitting diode obtained by magnifying the AA section shown in FIG. 6;
FIG. 8 is a flow chart of a manufacturing method for a display panel according to one embodiment of the present disclosure;
FIGS. 9A through 9D are each a cross-sectional view schematically illustrating a step of a manufacturing method for a display panel according to one embodiment of the present disclosure;
FIG. 10 is an illustration of a cross-section of a light-emitting diode obtained by magnifying the AA section shown in FIG. 6;
FIG. 11 is a graph of X-ray Reflectivity (XRR) of a first conductive layer according to one experimental example;
FIG. 12 is a block diagram of an electronic device according to one embodiment of the present disclosure; and
FIG. 13 is an illustration of schematic diagrams of an electronic device according to various embodiments.

### DETAILED DESCRIPTION

References will now be made in detail to certain embodiments, of which examples are illustrated in the accompanying drawings, where like reference numerals refer to like elements throughout. The embodiments may have a variety of forms and permutations, but the present disclosure shall by no means be construed as being limited to the described embodiments. Rather, the present disclosure shall be construed to encompass all forms, permutations, equivalents and substitutes covered by the technical ideas and scope of the present disclosure. Accordingly, the embodiments are merely described below, by referring to the figures, to explain features of the present disclosure.

In the accompanying drawings, the thicknesses, ratios, and dimensions of the elements may not be to exact scale and may have been exaggerated for the benefit of effective explanation of the technical features associated with these elements.

An expression such as "comprising" or "including" is intended to designate a characteristic, a number, a step, an operation, an element, a part or combinations thereof, and shall not be construed to preclude any possibility of presence or addition of one or more other characteristics, numbers, steps, operations, elements, parts or combinations thereof.

Terms such as "first" and "second" may be used in describing various elements, but the above elements shall not be restricted to the above terms. The above terms may be used only to distinguish one element from the other. For instance, the first element may be named the second element, and vice versa, without departing the scope of claims of the present disclosure. Unless clearly used otherwise, any expressions in a singular form may include a meaning of a plural form. The term "and/or" shall include the combination of a plurality of listed items or any of the plurality of listed items.

Unless otherwise defined, all terms, including technical terms and scientific terms, used herein have the same meaning as how they are generally understood by those of ordinary skill in the art to which the present disclosure pertains. Any term that is defined in a general dictionary shall be construed to have the same meaning in the context of the relevant art, and, unless otherwise defined explicitly, shall not be interpreted to have an idealistic or excessively formalistic meaning.

A display device according to one embodiment may be applicable to various electronic devices. An electronic device according to one embodiment includes the described display device and further includes a module or a device having an additional function other than the display device.

At least one of X, Y, and Z" can be construed as X only, Y only, Z only, or any combination of two or more items X, Y, and Z (e.g., XYZ, XYY, YZ, ZZ).

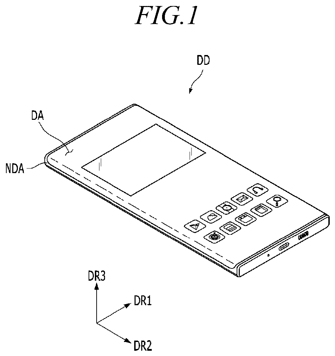

FIG. 1 is an illustration of a display device DD according to one embodiment of the present disclosure.

FIG. 1 illustrates a smartphone as a display device DD. However, a use of the display device DD is not limited to what is illustrated in the figure.

A display device DD may have a display region DA and a non-display region NDA defined therein. The display region DA may be configured to display an image and detect a user's input.

At least a portion of the display region DA may be parallel to a plane defined by a first directional axis DR1 and a second directional axis DR2. A normal direction of the display region DA, i.e. a thickness direction of the display device DD, may be directed by a third directional axis DR3. A front surface (or an upper surface) and a back surface (or a lower surface) of each member may be distinguished by the third directional axis DR3. However, directions pointed by the first through the third directional axes DR1, DR2 and DR3 are merely a relative concept and may be converted into other directions. Hereinafter, a first through a third directions DR1, DR2 and DR3 are directions pointed by the first through the third directional axes DR1, DR2 and DR3, respectively, and described with the same figure references.

A shape of the display region DA shown in FIG. 1 is merely an example and may be modified without limitation.

The non-display region NDA may be a region adjacent to the display region DA and a region that does not display an image. A bezel region of the display device DD may be defined by the non-display region NDA. The display region DA may be surrounded by the non-display region NDA. Yet, a shape of the non-display region NDA is not limited to the above. A shape of the display region DA and a shape of the non-display region NDA may be modified.

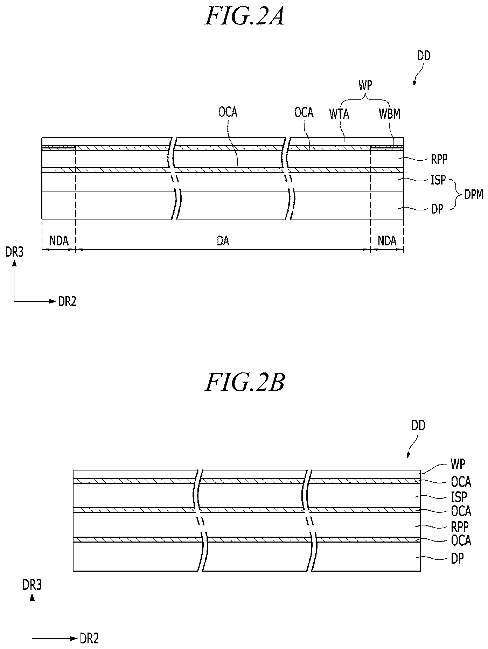

FIGS. 2A through 2D are cross-sectional views of a display device DD according to one embodiment of the present disclosure.

FIGS. 2A through 2D illustrate a cross-section defined by the second directional axis DR2 and the third directional axis DR3. FIGS. 2A through 2D are simplified to describe lamination relationships among functional panels and/or functional members composing the display device DD shown in FIGS. 2A through 2D.

Referring to FIG. 2A, the display device DD may include a display module DPM, a reflection protection member RPP, a window member WP, and a plurality of adhesive units OCA.

The display module DPM may include a display panel DP and an input sensor unit ISP. The display module DPM may be configured to emit light and detect an input. A base member may be further disposed below the display module DPM.

The display panel DP may be configured to emit light. The display panel DP may be a light-emitting display panel. The display panel DP may be an organic light-emitting display panel, a quantum dot light-emitting display panel or a micro light-emitting display panel.

The input sensor unit ISP may be disposed on the display panel DP. The input sensor unit ISP may be configured to obtain coordination information of an external input. Particularly at least one of a capacitance type input sensor, a resistance film type input sensor, an optical sensor, an electromagnetic resonance type input sensor, an ultrasonic type input sensor and an infrared wave type input sensor may be used as the input sensor unit ISP.

The reflection protection member RPP may be disposed on the display module DPM. In addition, the reflection protection member RPP may be configured to reduce light reflectivity of external light incident from an upper side of the window member WP. According to one embodiment of the present disclosure, the reflection protection member RPP may include a retarder, a polarizer and a plurality of color filters.

The window member WP may be disposed on the reflection protection member RPP. The window member WP may include a light penetration part WTA and a light block part WBM.

The light penetration part WTA may include glass and/or a synthetic resin. The light penetration part WTA is not limited to a single layer. The light penetration part WTA may include two or more films attached by an adhesive member. At least a portion of the light penetration part WTA may overlap with the display region DA of the display device DD.

The light block part WBM may partially overlap with the light penetration part WTA. The light block part WBM may be disposed below the light penetration part WTA and overlap with the non-display region NDA of the display device DD.

The plurality of adhesive members OCA may be optically transparent adhesive members. The plurality of adhesive members OCA may each be disposed between a below member and an upper member and configured to attach the below member and the upper member.

A portion of the plurality of adhesive members OCA may be disposed between the display module DPM and the reflection protection member RPP. The other portion of the plurality of adhesive members OCA may be disposed between the reflection protection member RPP and the window member WP.

A position of the plurality of adhesive members OCA is not limited to the above. The plurality of adhesive members OCA may be also disposed between the display panel DP and the input sensor unit ISP. In addition, at least some of the plurality of adhesive members OCA may be omitted.

Referring to FIG. 2B, the display device DD may include a display panel DP, a reflection protection member RPP, an input sensor unit ISP and a window member WP.

A portion of the plurality of adhesive members OCA may be disposed between the display panel DP and the reflection protection member RPP. Another portion of the plurality of adhesive members OCA may be disposed between the reflection protection member RPP and the input sensor unit ISP. Yet another portion of the plurality of adhesive members OCA may be disposed between the input sensor unit ISP and the window member WP.

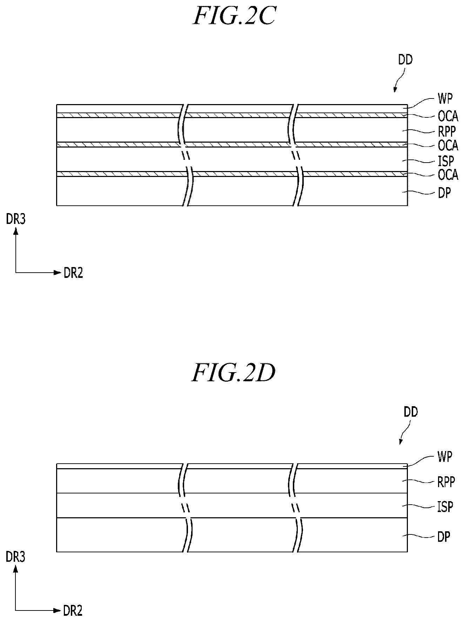

Referring to FIG. 2C, in the lamination structure shown in FIG. 2B, positions of the reflection protection member RPP and the input sensor unit ISP may be switched.

Referring to FIG. 2D, the plurality of adhesive members OCA may be omitted in the display device DD, and the display panel DP, the input sensor unit ISP, the reflection protection member RPP and the window member WP may be successively laminated. In another embodiment of the present disclosure, a lamination order of the input sensor unit ISP and the reflection protection member RPP may be switched.

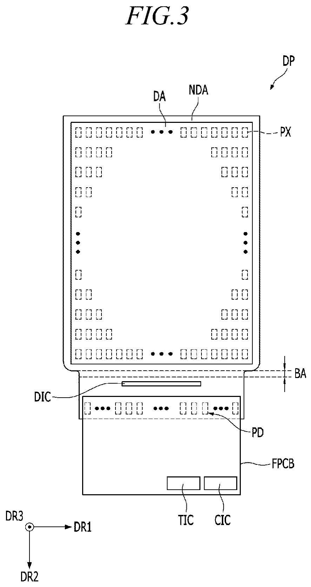

FIG. 3 is an illustration of a plan view of a display panel DP according to one embodiment of the present disclosure. As used herein, the plan view is a view in a thickness direction (i.e., third direction DR3) of the display panel DP.

Referring to FIG. 3, the display panel DP may have a display region DA and a non-display region NDA defined therein. The non-display region NDA may be defined along surrounding of the display region DA. The display region DA may correspond to the display region DA of the display device DD shown in FIG. 1. The non-display region NDA may correspond to the non-display region NDA of the display device DD shown in FIG. 1.

The display panel DP may include a plurality of pixels PX, a data integrated circuit DIC, a plurality of pads PD, a flexible printed circuit board FPCB, an input sensor integrated circuit TIC, and a control integrated circuit CIC.

The data integrated circuit DIC may be electrically connected to the pixels PX of the display region DA and configured to provide data signal to the pixels PX.

The input sensor integrated circuit TIC and the control integrated circuit CIC may be mounted in the flexible printed circuit board FPCB and configured to receive electronic signal from the plurality of pads PD.

The input sensor integrated circuit TIC may use the plurality of pads PD to process a signal corresponding to a change of current applied to the display area DA due to a user's touch or a signal corresponding to an applied external pressure via the input sensor unit ISP.

The control integrated circuit CIC may be a circuit configured to control at least one of the data integrated circuit DIC and the input sensor integrated circuit TIC.

A bending region BA of the display panel DP may be bent.

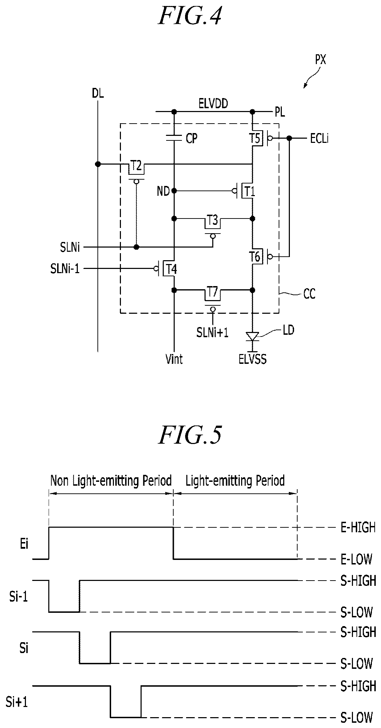

FIG. 4 illustrates an equivalent circuit of a pixel PX according to one embodiment of the present disclosure. FIG. 5 is an illustration of light-emission control signals Ei and scan signals Si-1, Si and Si+1 applied to the pixel PX shown in FIG. 4. FIG. 4 is an illustration of the pixel PX connected to an i-th scan line SLNi and an i-th light-emitting control line ECLi.

The pixel PX may include a light-emitting diode LD and a pixel circuit CC. The pixel circuit CC may include a plurality of transistors T1 through T7 and a capacitor CP. The pixel circuit CC may be configured to control an amount of current flowing through the light-emitting diode LD in response to a data signal.

The light-emitting diode LD may be configured to emit light with a selectable luminance corresponding to the amount of current provided from the pixel circuit CC. To that end, a level of a first power ELVDD may be set higher than a level of a second power ELVSS.

The plurality of transistors T1 to T7 may each include an input electrode (or a source electrode), an output electrode (or a drain electrode), and a control electrode (or a gate electrode). In the present disclosure, for convenience, one of the input electrode and the output electrode may be referred to as a first connection electrode, and the other may be referred to as a second connection electrode.

The first connection electrode of the first transistor T1 is connected to the first power ELVDD via the fifth transistor T5, and the second connection electrode is connected to the first connection electrode of the light-emitting diode LD via the sixth transistor T6. The first transistor T1 may be referred to as a driving transistor in this specification.

The first transistor T1 is configured to control an amount of current flowing through the light-emitting diode LD in response to a voltage applied to the control electrode.

The second transistor T2 is connected between the data line DL and the first connection electrode of the first transistor T1. In addition, the control electrode of the second transistor T2 is connected to the i-th scan line SLNi. In the case that the i-th scan signal Si is provided to the i-th scan line SLNi, the second transistor T2 is turned on to electrically connect the data line DL and the first connection electrode of the first transistor T1.

The third transistor T3 is connected between the second connection electrode and the control electrode of the first transistor T1. The control electrode of the third transistor T3 is connected to the i-th scan line SLNi. In the case that the i-th scan signal Si is provided to the i-th scan line SLNi, the third transistor T3 is turned on to electrically connect the second connection electrode and the control electrode of the first transistor T1. Accordingly, in the case that the third transistor T3 is turned on, the first transistor T1 is connected in a form of a diode.

The fourth transistor T4 is connected between a node ND and an initialization power generation unit (not shown). In addition, the control electrode of the fourth transistor T4 is connected to the (i-1)-th scan line SLNi-1. When the (i-1)-th scan signal Si-1 is provided to the (i-1)-th scan line SLNi-1, the fourth transistor T4 is turned on to provide an initialization voltage Vint to the node ND.

The fifth transistor T5 is connected between a power line PL and the first connection electrode of the first transistor T1. The control electrode of the fifth transistor T5 is connected to the i-th light-emission control line ECLi.

The sixth transistor T6 is connected between the second connection electrode of the first transistor T1 and the first driving electrode of the light-emitting diode LD. In addition, the control electrode of the sixth transistor T6 is connected to the i-th light-emission control line ECLi.

The seventh transistor T7 is connected between the initialization power generation unit (not shown) and the first driving electrode of the light-emitting diode LD. In addition, the control electrode of the seventh transistor T7 is connected to the (i+1)-th scan line SLNi+1. In the case that the (i+1)-th scan signal Si+1 is provided to the (i+1)-th scan line SLNi+1, such seventh transistor T7 is turned on to provide the initialization voltage Vint to the first driving electrode of the light-emitting diode LD.

The seventh transistor T7 may improve black expression capability of the pixel PX. Particularly, in the case that the seventh transistor T7 is turned on, a parasitic capacitor (not shown) of the light-emitting diode LD is discharged. Then, in the case that black luminance is implemented, the light-emitting diode LD does not emit light due to the leakage current from the first transistor T1, and accordingly, the black expression capability may be improved.

Additionally, in FIG. 4, the control electrode of the seventh transistor T7 is shown to be connected to the (i+1)-th scan line SLNi+1, but the present disclosure is not limited to this configuration. In another embodiment of the present disclosure, the control electrode of the seventh transistor T7 may be connected to the i-th scan line SLNi or the (i-1)-th scan line SLNi-1.

Illustration of FIG. 4 is based on PMOS, but the present disclosure is not limited to this configuration. In another embodiment of the present disclosure, the pixel PX may be composed of NMOS. In another embodiment of the present disclosure, the pixel PX may be composed of a combination of NMOS and PMOS.

The capacitor CP is disposed between the power line PL and the node ND. The capacitor CP is configured to store a voltage corresponding to the data signal. In the case that the fifth transistor T5 and the sixth transistor T6 are turned on, the amount of current flowing through the first transistor T1 may be determined according to the voltage stored in the capacitor CP.

In the present disclosure, a structure of the pixel PX is not limited to what is illustrated in FIG. 4. In another embodiment of the present disclosure, the pixel PX may be implemented in various forms configured for the light-emitting diode LD to emit light.

Referring to FIG. 5, the light emission control signal Ei may have a high level E-HIGH or a low level E-LOW. The scan signals Si-1, Si, and Si+1 may each have a high level S-HIGH or a low level S-LOW.

In the case that the light emission control signal Ei has a high level E-HIGH, the fifth transistor T5 and the sixth transistor T6 are turned off. In the case that the fifth transistor T5 is turned off, the power line PL and the first connection electrode of the first transistor T1 are electrically cut off. In the case that the sixth transistor T6 is turned off, the second connection electrode of the first transistor T1 and the first driving electrode of the light-emitting diode LD are electrically cut off. Accordingly, the light-emitting diode LD does not emit light while the light emission control signal Ei having a high level E-HIGH is provided to the i-th light emission control line ECLi.

Thereafter, in the case that the (i-1)-th scan signal Si-1 to be provided to the (i-1)-th scan line SLNi-1 has a low level S-LOW, the fourth transistor T4 is turned on. In the case that the fourth transistor T4 is turned on, the initialization voltage Vint is provided to the node ND.

In the case that the i-th scan signal Si provided to the i-th scan line SLNi has a low level S-LOW, the second transistor T2 and the third transistor T3 are turned on.

In the case that the second transistor T2 is turned on, a data signal is provided to the first connection electrode of the first transistor T1. Here, since the node ND is initialized to the initialization voltage Vint, the first transistor T1 is turned on. In the case that the first transistor T1 is turned on, a voltage corresponding to the data signal is provided to the node ND. Here, the capacitor CP stores a voltage corresponding to the data signal.

In the case that the (i+1)-th scan signal Si+1 to be provided to the (i+1)-th scan line SLNi+1 has a low level S-LOW, the seventh transistor T7 is turned on.

In the case that the seventh transistor T7 is turned on, the initialization voltage Vint is provided to the first driving electrode of the light-emitting diode LD, thereby discharging the parasitic capacitor of the light-emitting diode LD.

In the case that the light emission control signal Ei to be provided to the light emission control line ECLi has a low level E-LOW, the fifth transistor T5 and the sixth transistor T6 are turned on. In the case that the fifth transistor T5 is turned on, the first power ELVDD is provided to the first connection electrode of the first transistor T1. When the sixth transistor T6 is turned on, the second electrode of the first transistor T1 and the anode electrode of the light-emitting diode LD are electrically connected. Then, the light-emitting diode LD generates light of a predetermined luminance in response to the amount of supplied current.

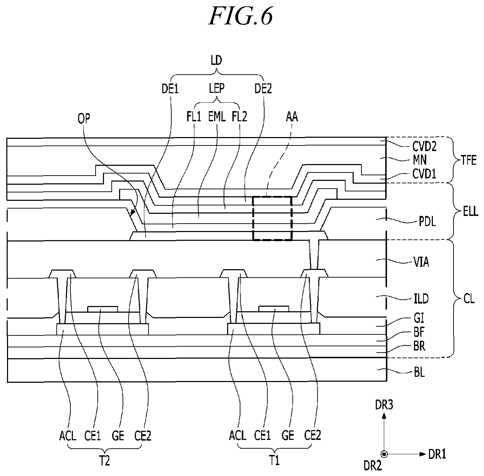

FIG. 6 is a cross-sectional view of a base member BL and a display panel DP according to one embodiment of the present disclosure.

Referring to FIG. 6, a display panel DP may be disposed on a base member BL.

The base member BL may be a base of the display panel DP. That is, other elements of the display panel DP may be laminated on the base member BL. The base member BL may include an organic layer and/or an inorganic layer. The organic layer may include an organic material. For example, polyimide may be included. The inorganic layer may include an inorganic material.

The display panel DP may include a circuit layer CL, a light-emitting diode layer ELL and an encapsulation layer TFE. Light may be emitted from the display panel DP.

The circuit layer CL may include a barrier layer BR, a buffer layer BF, a gate insulating layer GI, an interlayer insulating layer ILD, a circuit insulating layer VIA, a first transistor T1 and a second transistor T2.

The first transistor T1 and the second transistor T2 may be configured to transfer electric signal. In addition, the first transistor T1 and the second transistor T2 may include a plurality of active parts ACL, a plurality of first connection electrodes CE1, a plurality of control electrodes GE and a plurality of second connection electrodes CE2.

The barrier layer BR may be disposed on the base member BL. The barrier layer BR may be configured to prevent penetration of, for example, moisture introduced from outside. The barrier layer BR may include an inorganic insulating material, such as silicon oxide and silicon nitride.

The buffer layer BF may be disposed on the barrier layer BR. The buffer layer BF may be configured to interfere transfer of impurities introduced from bottom to above. Accordingly, an element disposed on the buffer layer BF may be protected. The buffer layer BF may include an inorganic insulating material, such as silicon oxide and silicon nitride.

The plurality of active parts ACL may be disposed on the buffer layer BF. The plurality of active parts ACL may include polysilicon or amorphous silicon. Other than the above, the plurality of active parts ACL may include metallic oxide semiconductor. The active parts ACL may include a channel area serving as a passage through which electrons or holes may move, and a first ion-doped area and a second ion-doped area disposed with the channel area therebetween.

The gate insulating layer GI may cover the buffer layer BF and the plurality of active parts ACL. The gate insulating layer GI may include an organic film and/or an inorganic film. The gate insulating layer GI may include a plurality of inorganic thin films. The plurality of inorganic thin films may include a silicon nitride layer and a silicon oxide layer.

The plurality of control electrodes GE may be disposed on the buffer layer BF. The plurality of control electrodes GE may overlap with the plurality of active parts ACL. In addition, the plurality of control electrodes GE may include molybdenum (Mo).

The interlayer insulating layer ILD may cover the gate insulating layer GI and a plurality of control electrodes GE. The interlayer insulating layer ILD may include an organic film and/or an inorganic film. The interlayer insulating layer ILD may include a plurality of inorganic thin films or organic thin films. The plurality of inorganic thin films may include a silicon nitride layer and a silicon oxide layer.

The plurality of first connection electrodes CE1 and a plurality of second connection electrodes CE2 may be disposed on the interlayer insulating layer ILD. The plurality of first connection electrodes CE1 and the plurality of second connection electrodes CE2 may be electrically connected to the plurality of active parts ACL through a plurality of contact holes defined on the interlayer insulating layer ILD. In addition, the plurality of first connection electrodes CE1 and the plurality of second connection electrodes CE2 may include a metal.

The circuit insulating layer VIA may cover the interlayer insulating layer ILD, the plurality of first connection electrodes CE1 and the plurality of second connection electrodes CE2. The circuit insulating layer VIA may include an organic film and/or an inorganic film. The circuit insulating layer VIA may provide a flat surface. In another embodiment, a number of the circuit insulating layer VIA may be increased.

The light-emitting diode layer ELL may include a pixel definition film PDL and a light-emitting diode LD. The light-emitting diode layer ELL may be configured to emit light.

The pixel definition film PDL may be disposed on a portion of the circuit insulating layer VIA. An opening OP may be defined on another portion where the pixel definition film PDL is not disposed. In addition, a light-emitting diode LD may be formed in the opening OP.

The light-emitting diode LD may be configured to emit light. In addition, the light-emitting diode LD may include a first driving electrode DE1, a light-emitting part LEP and a second driving electrode DE2.

The first driving electrode DE1 may be disposed on a portion of the circuit insulating layer VIA. The first driving electrode DE1 may be disposed in the opening OP. In addition, the first driving electrode DE1 may be electrically connected to any one of the plurality of second connection electrodes CE2 through a contact hole defined on the circuit insulating layer VIA. Accordingly, the first driving electrode DE1 may be configured to receive electrical signal from the first transistor T1 and the second transistor T2.

Although FIG. 6 illustrates a first transistor T1 and a second transistor T2, a structure of the first transistor T1 and the second transistor T2 is not limited to what is illustrated in the figure. In FIG. 6, the first transistor T1 is illustrated to make direct contact with the first driving electrode DE1 through any of the plurality of second connection electrodes CE2, but this merely is a cross-sectional shape, and in fact, the first transistor T1 may be connected to the first driving electrode DE1 through another transistor. However, the present disclosure is not limited to this configuration, and in another embodiment of the present disclosure, the first transistor T1 may make direct contact with the first driving electrode DE1 through any of the plurality of second connection electrodes CE2.

The first driving electrode DE1 may be an anode electrode of the light-emitting diode LD. A hole may be provided through the first driving electrode DE1. In another embodiment, a configuration of the first driving electrode DE1 is not limited to the above. In another embodiment of the present disclosure, the first driving electrode DE1 may be a cathode electrode of the light-emitting diode LD and be configured to provide an electron, and a configuration and an effect of the first functional layer FL1 and the second functional layer FL2 may be switched.

The light-emitting part LEP may include a first functional layer FL1, a light-emitting layer EML, and a second functional layer FL2. Light may be emitted from the light-emitting part LEP.

The first functional layer FL1 may be disposed on the first driving electrode DE1. The first functional layer FL1 may be configured to support transfer of a hole generated from the first driving electrode DE1. For example, the first functional layer FL1 may be configured to easily receive a hole injected from the first driving electrode DE1 and facilitate transfer of a hole. The first functional layer FL1 may have a multi-layer structure. For example, the first functional layer FL1 may have a structure further including a first injection layer (not shown) and a first transfer layer (not shown).

The light-emitting layer EML may be disposed on the first functional layer FL1. Light may be emitted from the light-emitting layer EML. The light-emitting layer EML may include, for example, an organic light-emitting material or a quantum dot. Accordingly, the light-emitting diode LD may be an organic light-emitting diode or a quantum dot light-emitting diode.

The second functional layer FL2 may be disposed on the light-emitting layer EML. The second functional layer FL2 may be configured to support transfer of an electron generated from the second driving electrode DE2. For example, the second functional layer FL2 may be configured to easily receive an electron injected from the second driving electrode DE2 and facilitate transfer of an electron. The second functional layer FL2 may have a multi-layer structure. For example, the second functional layer FL2 may have a structure further including a second injection layer (not shown) and a second transfer layer (not shown).

The second driving electrode DE2 may be disposed on the light-emitting part LEP. The second driving electrode DE2 may have a low sheet resistance value so that current may easily flow through the second driving electrode DE2. In the case that a sheet resistance value of the second driving electrode DE2 is large, a portion having low luminance may be generated in the display region DA shown in FIG. 1 so that visibility of the display region DA may decrease.

The second driving electrode DE2 may be a cathode electrode of the light-emitting diode LD. An electron may be provided through the second electrode DE2. However, a configuration of the second driving electrode DE2 is not limited to the above. In another embodiment of the present disclosure, the second driving electrode DE2 may be an anode electrode of the light-emitting diode LD and be configured to provide a hole, and a configuration and an effect of the first functional layer FL1 and the second functional layer FL2 may be switched.

The second driving electrode DE2 may be configured to allow penetration of incident light by a selectable light penetration rate. Light penetrating the second driving electrode DE2 may be emitted to the outside of the display device DD and visible to a user.

The second driving electrode DE2 may be configured to reflect incident light by a selectable light reflection rate. Light reflected by the second driving electrode DE2 may be reflected by the first driving electrode DE1 again and generate a resonance phenomenon in the light-emitting diode LD. As the resonance phenomenon is generated in the light-emitting diode LD, light efficiency of the light-emitting diode LD may increase.

The second driving electrode DE2 may be configured to absorb incident light by a selectable light absorption rate. Light absorbed by the second driving electrode DE2 may decrease light efficiency of the light-emitting diode LD. In other words, in the case that a light absorption rate of the second driving electrode DE2 is lowered, light efficiency of the light-emitting diode LD may increase.

Before the second driving electrode DE2 is disposed, the light-emitting part LEP may be heated. Particularly, the light-emitting part LEP may be heated to a temperature higher than or equal to 70 °C and lower than or equal to 90 °C for 20 minutes or more and 30 minutes or less. The light-emitting part LEP may be heated under a vacuum environment.

The second driving electrode DE2 may be formed by being deposited on the light-emitting part LEP having a temperature higher than or equal to 60 °C and lower than or equal to 90 °C. Accordingly, during deposition of the second driving electrode DE2, a grain size of the second driving electrode DE2 may increase, and film quality of the second driving electrode DE2 may be improved.

In addition, the second driving electrode DE2 may be formed by being deposited on the light-emitting part LEP expanded by heat. Accordingly, in the case that the light-emitting part LEP is cooled, compression stress may be formed on the second driving electrode DE2 by contraction of the light-emitting part LEP. A detailed description of a configuration of the second driving electrode DE2 will be made with reference to another figure in greater detail.

The encapsulation layer TFE may be configured to seal the light-emitting diode LD to protect the light-emitting diode LD from external oxygen or moisture. The encapsulation layer TFE may include a first encapsulation inorganic layer CVD1, an encapsulation organic layer MN, a second encapsulation inorganic layer CVD2.

In FIG. 6, it is illustrated that the encapsulation layer TFE includes two encapsulation inorganic layers CVD1 and CVD2 and one encapsulation organic layer MN, but the present disclosure is not limited thereto. For example, the encapsulation layer TFE may include three encapsulation inorganic layers and two encapsulation organic layers, and in this case, the encapsulation inorganic layers and the encapsulation organic layers may be alternatingly laminated.

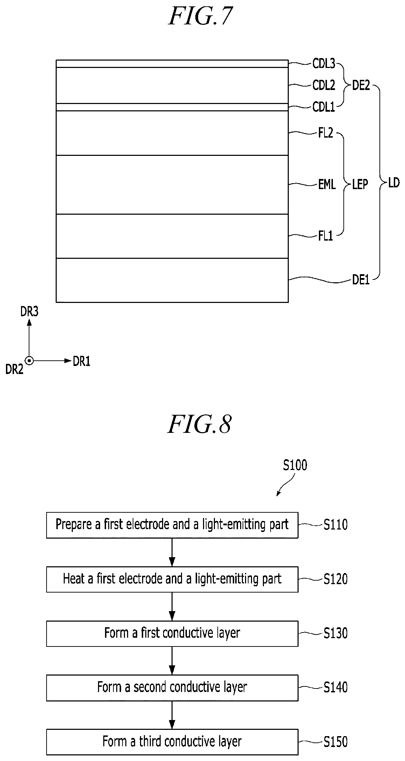

FIG. 7 is an illustration of a cross-section of a light-emitting diode LD obtained by magnifying the AA section shown in FIG. 6.

Referring to FIG. 7, the second driving electrode DE2 may include a first conductive layer CDL1, a second conductive layer CDL2 and a third conductive layer CDL3. The second conductive layer CDL2 may be configured to conduct electricity. In addition, the first conductive layer CDL1 and the third conductive layer CDL3 may be configured to support electricity conduction of the second conductive layer CDL2.

The first conductive layer CDL1 may be configured to prevent aggregation of the second conductive layer CDL2. The first conductive layer CDL1 may be configured to prevent diffusion of a material composing the second conductive layer CDL2 downward.

The first conductive layer CDL1 may have a first thickness. The first thickness may be greater than or equal to 5 Ångström and smaller than or equal to 20 Ångström. In the case that the first thickness is smaller than 5 Ångström, the first conductive layer CDL1 may not be able to support electricity conduction of the second conductive layer CDL2. In the case that the first thickness is greater than 20 Ångström, electricity conductivity of the second conductive layer CDL2 may decrease by the first conductive layer CDL1, and a light absorption rate of the second driving electrode DE2 may increase.

The first conductive layer CDL1 may include a metal having high a light absorption rate, such as ytterbium (Yb), nickel (Ni) and copper (Cu). The first conductive layer CDL1 may include a metal, such as aluminium (Al) or gold (Au), that can be thermally vacuum deposited. In addition, the first conductive layer CDL1 may include a material, such as lithium fluoride (LiF), that reduces a work function.

The first conductive layer CDL1 may be formed through a deposition process. The first conductive layer CDL1 may be formed through co-deposition of different materials. Accordingly, the first conductive layer CDL1 may be formed by mixing different materials.

The conductive layer CDL2 has a second thickness. The second thickness is greater than or equal to 7 times of the first thickness and smaller than or equal to 15 times of the first thickness. In the case that the second thickness is smaller than 7 times of the first thickness, the thickness of the second conductive layer CDL2 may be small so that an effect of increasing electricity conductivity of the second conductive layer due to assistance of the first conductive layer CDL1 may be small. In the case that the second thickness is greater than 15 times of the first thickness, a thickness of the first conductive layer CDL1 may be small so that an effect of increasing electricity conductivity of the second conductive layer due to assistance of the first conductive layer CDL1 may be small

The second thickness may be greater than or equal to 35 Ångström and smaller than or equal to 300 Ångström. In the case that the second thickness is less than 35 Ångström, sheet resistance of the second driving electrode DE2 may increase. In addition, in the case that the second thickness is greater than 300 Ångström, a light absorption rate of the second driving electrode DE2 may increase.

The second conductive layer CDL2 includes silver (Ag). A silver content of the second conductive layer CDL2 may be greater than or equal to 90% with respect to the total content of the second conductive layer CDL2. In addition, the second conductive layer CDL2 may further include other metals, such as magnesium (Mg), ytterbium (Yb) and copper (Cu). In an embodiment, the combination of materials of the second conductive layer CDL2 may be different from the combination of materials of the first conductive layer CDL1. In an embodiment, while the first conductive layer CDL1 and the second conductive layer CDL2 include the same material, the content (%) of the material in the layers may be different from each other.

The second conductive layer CDL2 may be formed through a deposition process. The second conductive layer CDL2 may be formed through co-deposition. Accordingly, the second conductive layer CDL2 may be formed with an alloy including silver (Ag).

The third conductive layer CDL3 may be configured to prevent aggregation of the second conductive layer CDL2. The third conductive layer CDL3 may be configured to prevent diffusion of materials composing the second conductive layer CDL2 upward.

The third conductive layer CDL3 may have third thickness. The third thickness may be smaller than the second thickness. The third thickness may be greater than or equal to 5 Ångström and smaller than or equal to 20 Ångström. In the case that the third thickness is smaller than 5 Ångström, the third conductive layer CDL3 may not support electricity conduction of the second conductive layer CDL2. In the case that the third thickness is greater than 20 Ångström, a light absorption rate of the second driving electrode DE2 may increase.

The third conductive layer CDL3 may include ytterbium (Yb), nickel (Ni), copper (Cu), aluminium (Al), gold (Au) or lithium fluoride (LiF).

The third conductive layer CDL3 may be formed through a deposition process. In addition, the third conductive layer CDL3 may be formed through co-deposition of different materials. In another embodiment, the third conductive layer CDL3 may be omitted. In an embodiment, the combination of materials of the third conductive layer CDL3 may be different from the combination of materials of the second conductive layer CDL2. In an embodiment, while the second conductive layer CDL2 and the third conductive layer CDL3 include the same material, the content (%) of the material in the layers may be different from each other.

A total thickness of the second driving electrode DE2 may be greater than or equal to 45 Ångström and smaller than or equal to 340 Ångström. In another embodiment, a total thickness of the second driving electrode DE2 may be greater than or equal to 80 Ångström and smaller than or equal to 200 Ångström. In the case that a total thickness of the second driving electrode DE2 is smaller than 80 Ångström, sheet resistance of the second driving electrode DE2 may be high. In addition, in the case that a total thickness of the second driving electrode DE2 is greater than 200 Ångström, a light absorption rate of the second driving electrode DE2 may be high.

The second driving electrode DE2 may have a crystal structure. In addition, the second driving electrode DE2 may have a face-centered cubic lattice crystal structure as in Bravais Lattice.

In the crystal structure of the second driving electrode DE2, a plurality of crystal planes having a selectable dense Miller Index may be defined as a plurality of dense planes. In addition, the dense Miller Index may be a Miller Index defining a plane having greatest planar density. For example, in the case that the crystal structure is a face-centered cubic lattice crystal structure, the dense Miller Index may be (111). In the crystal structure, a plurality of crystal planes having greatest planar density among a plurality of crystal planes may be defined as a plurality of dense planes.

In another embodiment, in the crystal structure of the second driving electrode DE2, a plurality of planes having a selectable non-dense Miller Index different from the selectable dense Miller Index may be defined as a plurality of non-dense planes. For example, in the case that the crystal structure is a face-centered cubic lattice crystal structure, the non-dense Miller Index may be (220). The plurality of non-dense planes may intersect with the dense planes.

In the second driving electrode DE2, a value obtained my dividing an area of the plurality of dense planes by an area of the plurality of non-dense planes may be defined as a density orientation. The density orientation may affect electricity conductivity and optical properties of the second driving electrode DE2. For example, as the plurality of dense planes have a high atomic density, movement of an electron may be easy. Accordingly, if a density orientation increases, electricity conductivity may also increase. However, in the case that the density orientation is excessively increased, an amount of crystallographic defect may increase, and electricity conductivity may decrease. The density orientation may be greater than or equal to 5.4 and smaller than or equal to 6.4.

The density orientation of the second driving electrode DE2 may be measured through X-ray diffraction ("XRD") analysis. Through the X-ray diffraction analysis, an X-ray diffraction pattern of the second driving electrode DE2 may be obtained. From the X-ray diffraction pattern, a diffraction peak by the plurality of dense planes and a diffraction peak by the plurality of non-dense planes may be determined. The density orientation of the second driving electrode DE2 may be a value confirming a comparison of the diffraction peak by the plurality of dense planes and the diffraction peak by the plurality of non-dense planes.

The X-ray diffraction (XRD) analysis described herein may be performed using Cu Kα radiation under standard measurement conditions. For example, the measurement may be carried out at room temperature under atmospheric pressure. The XRD pattern may be obtained using a flat-plate geometry diffractometer.

In the case that the density orientation is smaller than 5.4, an amount of the plurality of dense planes is small, and electricity conductivity of the second driving electrode DE2 may be low. In the case that the density orientation is greater than 6.4, an amount of crystallographic defects increases, and electricity conductivity of the second driving electrode DE2 may decrease.

A size of the plurality of dense planes of the second electrode DE2 may be greater than or equal to 56.5 Ångström and smaller than or equal to 67.5 Ångström. As the second driving electrode DE2 is formed on the heated light-emitting part LEP, a size of the plurality of dense planes of the second driving electrode DE2 may increase.

The size of the plurality of dense planes of the second driving electrode DE2 may be measured by X-ray diffraction (XRD) analysis of the second driving electrode DE2. The size of the plurality of dense planes of the second driving electrode DE2 may be a calculated value with a full width at half maximum of a diffraction peak full width at half maximum (FWHM) by the plurality of dense planes and Scherrer Equation.

In the case that a size of the plurality of dense planes of the second driving electrode DE2 increases, electricity may encounter a less amount of crystalline interface during conduction. Accordingly, electricity conductivity of the second driving electrode DE2 may be improved. Therefore, film quality of the second driving electrode DE2 may be improved.

In addition, a distance between the plurality of dense planes adjacent to each other and parallel to each other among the plurality of dense planes of the second driving electrode DE2 may be an interplanar distance of the plurality of dense planes. The interplanar distance of the plurality of dense planes may be greater than or equal to 2.350 Ångström and smaller than or equal to 2.352 Ångström. As the second driving electrode DE2 is formed on a heated light-emitting part LEP, the interplanar distance between the plurality of dense planes of the second driving electrode DE2 may decrease.

The interplanar distance of the plurality of dense planes of the second driving electrode DE2 may be measured through an X-ray diffraction (XRD) analysis of the second driving electrode DE2. The interplanar distance between the plurality of dense planes of the second driving electrode DE2 may be a calculated value with a diffraction angle of a diffraction peak by the plurality of dense planes and Bragg's Law.

The second driving electrode DE2 may be formed on the light-emitting part LEP having a temperature greater than or equal to 60 °C and lower than 90 °C . Accordingly, the second driving electrode DE2 may be disposed on the light-emitting part LEP expanded by heat. In addition, while the light-emitting part LEP is cooled to a room temperature, compression stress may be caused on the second driving electrode DE2.

As a result, it may be confirmed that the interplanar distance of the plurality of dense planes of the second driving electrode DE2 decreases. In the case that the interplanar distance between the plurality of dense planes of the second driving electrode DE2 decreases, a film density may increase. Accordingly, electricity conductivity of the second driving electrode DE2 may be improved. Therefore, film quality of the second driving electrode DE2 may be improved.

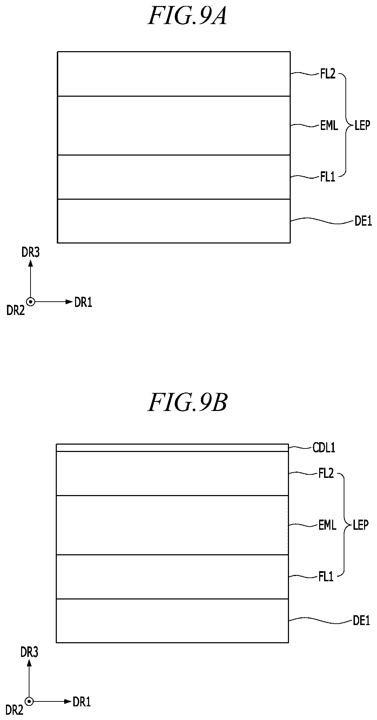

FIG. 8 is a flow chart of a manufacturing method for a display panel S100 according to one embodiment of the present disclosure. Each of FIGS. 9A through 9D is a cross-sectional view schematically illustrating a step of a manufacturing method for a display panel S100 according to one embodiment of the present disclosure.

FIGS. 8 and 9A through 9D show a manufacturing method for a display panel according to one embodiment of the present disclosure. The same figure reference is marked for an element explained with reference to FIGS. 1 through 7, and a description thereof is omitted.

Referring to FIG. 8, the manufacturing method for a display panel S100 of the present disclosure may include preparing S110, heating S120, forming a first conductive layer S130, forming a second conductive layer S140 and forming a third conductive layer S150.

Referring to FIGS. 8 and 9A, in the step of preparing S110, a first driving electrode DE1 and a light-emitting part LEP may be prepared.

In the step of heating S120, the first driving electrode DE1 and the light-emitting part LEP may be heated. The first driving electrode DE1 and the light-emitting part LEP may be heated under a temperature higher than or equal to 70 °C and lower than or equal to 90 °C. The first driving electrode DE1 and the light-emitting part LEP may be heated for a time longer than or equal to 20 minutes and shorter than or equal to 30 minutes. Furthermore, the first driving electrode DE1 and the light-emitting part LEP may be heated under a vacuum environment.

In the case that the first driving electrode DE1 and the light-emitting part LEP are heated under a temperature lower than 70 °C in the step of heating S120, an effect of the step of heating S120 may not be sufficient. In the case that the first driving electrode DE1 and the light-emitting part LEP is heated under a temperature higher than 90 °C in the step of heating S120, at least one of the first driving electrode DE1 and the light-emitting part LEP may be damaged in the step of heating S120, and performance of the light-emitting diode LD may be deteriorated.

In the case that the first driving electrode DE1 and the light-emitting part LEP are heated for a time less than 20 minutes in the step of heating S120, the first driving electrode DE1 and the light-emitting part LEP may not be sufficiently heated, and an effect of the step of heating S120 may not be sufficient. In the case that the first driving electrode DE1 and the light-emitting part LEP are heated for a time longer than 30 minutes in the step of heating S120, more time and power are required in the step of heating S120, and efficiency of the step of heating S120 may be deteriorated.

Referring to FIGS. 8 and 9B, a first conductive layer CDL1 may be formed on the light-emitting part LEP in the step of forming a first conductive layer S130.

In the step of forming a first conductive layer S130, a deposition process is performed on the light-emitting part LEP to form a first conductive layer CDL1. In the step of forming a first conductive layer S130, a temperature of the light-emitting part LEP may be higher than or equal to 60 °C and lower than or equal to 90 °C.

In the case that a temperature of the light-emitting part LEP is lower than 60 °C in the step of forming a first conductive layer S130, film quality of the second driving electrode DE2 may not be improved, and compression stress may not be generated on the second driving electrode DE2. In the case that a temperature of the light-emitting part LEP is higher than 90 °C in the step of forming a first conductive layer S130, the first conductive layer CDL1 may be diffused towards the light-emitting part LEP, and performance of the second driving electrode DE2 and the light-emitting diode LD may be deteriorated.

In the step of forming a first conductive layer S130, for example, ytterbium (Yb), nickel (Ni), copper (Cu), aluminium (Al), gold (Au) or lithium fluoride (LiF) may be deposited. In addition, in the step of forming a first conductive layer S130, co-deposition may be performed. Accordingly, different deposition materials may be co-deposited on the light-emitting part LEP to form a first conductive layer CDL1.

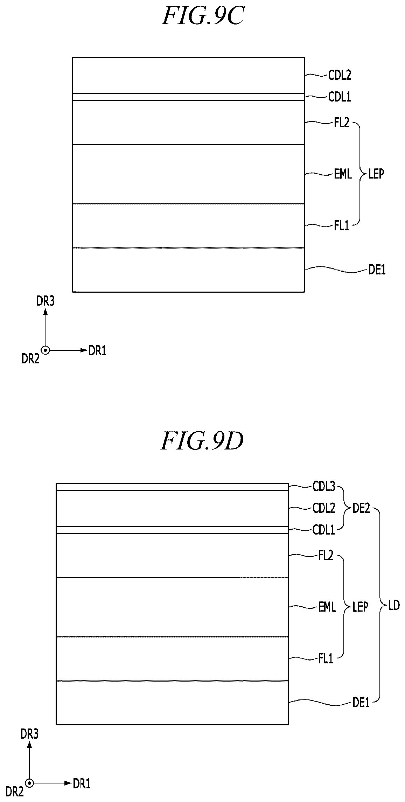

Referring to FIGS. 8 and 9C, in the step of forming a second conductive layer S140, a second conductive layer CDL2 may be formed on the first conductive layer CDL1.

In the step of forming a second conductive layer S140, a deposition process is performed on the first conductive layer CDL1 to form a second conductive layer CDL2. In the step of forming a second conductive layer S140, silver (Ag) is deposited. In addition, in the step of forming a second conductive layer S140, a co-deposition process may be performed. Accordingly, a first deposition material and a second deposition material different from each other may be simultaneously deposited on the first conductive layer CDL1 to form the second conductive layer CDL2. The first deposition material is silver (Ag). The second deposition material may be a metal. For example, the second deposition material may be any of magnesium (Mg), ytterbium (Yb) and copper (Cu).

Referring to FIGS. 8 and 9D, in the step of forming a third conductive layer S150, a third conductive layer CDL3 may be formed on the second conductive layer CDL2.

In the step of forming a third conductive layer S150, a deposition process may be performed on the second conductive layer CDL2 to form a third conductive layer CDL3.

In the step of forming a third conductive layer S150, for example, ytterbium (Yb), nickel (Ni), copper (Cu), aluminium (Al), gold (Au) or lithium fluoride (LiF) may be deposited. In addition, in the step of forming a third conductive layer S150, a co-deposition process may be performed. Accordingly, different deposition materials may be simultaneously deposited on the second conductive layer CDL2 to form a third conductive layer CDL3.

However, a manufacturing method for a display panel S100 of the present disclosure is not limited to the above. In a manufacturing method for a display panel S100 of the present disclosure, the step of forming a third conductive layer S150 may be omitted.

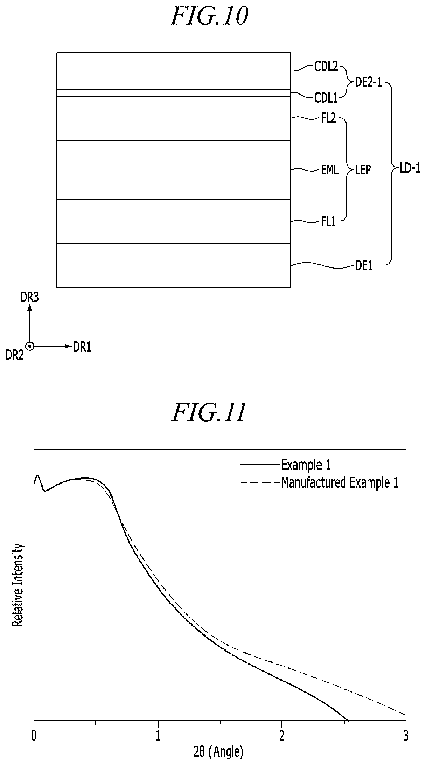

FIG. 10 is an illustration of a cross-section of a light-emitting diode LD-1 obtained by magnifying the AA section shown in FIG. 6.

Referring to FIG. 10, the second driving electrode DE2-1 includes a first conductive layer CDL1 and a second conductive layer CDL2. The second driving electrode DE2-1 shown in FIG. 10 may have the third conductive layer CDL3 of the second driving electrode DE2 shown in FIG. 7 omitted.

The second driving electrode DE2-1 shown in FIG. 10 and the second driving electrode DE2 shown in FIG. 7 may have a same or similar effect. For example, the second driving electrode DE2-1 may have a face-centered cubic lattice crystal structure, and a density orientation may be greater than or equal to 5.4 and smaller than or equal to 6.4. Accordingly, electricity conductivity may be excellent.

However, the second driving electrode DE2-1 shown in FIG. 10 and the second driving electrode DE2 shown in FIG. 7 may have a different thickness, size of a plurality of dense planes and interplanar distance of the plurality of dense planes. For example, a total thickness of the second driving electrode DE2-1 may be greater than or equal to 75 Ångström and smaller than or equal to 180 Ångström. A size of the plurality of dense planes of the second driving electrode DE2-1 may be greater than or equal to 54 Ångström and smaller than or equal to 64 Ångström. In addition, the interplanar distance of the plurality of dense planes of the second driving electrode DE2-1 may be greater than or equal to 2.345 Ångström and smaller than or equal to 2.349 Ångström.

Hereinafter, a light-emitting diode LD according to an experimental example of the present disclosure will be described.

### <Experimental Example 1>

In Experimental Example 1 of the present disclosure, film densities of conductive layers CDL1 are compared based on whether a heating process is performed on a first driving electrode DE1 and a light-emitting part LEP. The heating process was performed at 85 °C for 20 minutes. Ytterbium (Yb) was deposited on the light-emitting part LEP to form a first conductive layer CDL1. An X-ray reflection ("XRR") measurement was used to analyze a film density of the first conductive layer CDL1, and a thickness of the first conductive layer CDL1 was set to be 200 Ångström.

In Example 1, a first conductive layer CDL1 was formed after performing a heating process on a first driving electrode DE1 and a light-emitting part LEP. In contrast, in Manufactured Example 1, a heating process was not performed on a first driving electrode DE1 and a light-emitting part LEP to form a first conductive layer CDL1.

FIG. 11 is a graph of X-ray Reflectivity (XRR) of a first conductive layer CDL1 according to one experimental example.

Referring to FIG. 11, it can be confirmed in Experimental Example 1 of the present disclosure that a critical angle in Example 1 is greater than a critical angle in Manufactured Example 1. The critical angle may correspond to the point at which the relative intensity in the XRR curve begins to decrease sharply. A larger critical angle may indicate a higher film density.

Accordingly, it can be confirmed that a film density in Example 1 is greater than a film density in Manufactured Example 1. As a result, it can be confirmed that as the first driving electrode DE1 and the light-emitting part LEP are heated, a film density of the first conductive layer CDL1 increases.

### Experimental Example 2

In Experimental Example 2, a size of a plurality of dense planes of a second driving electrode DE2, and an interplanar distance and density orientation of the plurality of dense planes are obtained according to a configuration of a second driving electrode DE2 and whether a heating process is performed on a first driving electrode DE1 and a light-emitting part LEP. In a portion of the second driving electrode DE2, a third conductive layer CDL3 was included, and in another portion, the third conductive layer CDL3 was omitted. The heating process was performed at 85 °C for 20 minutes. Ytterbium (Yb) was deposited on the light-emitting part LEP to form a first conductive layer CDL1, and a thickness of the first conductive layer CDL1 was set to be 10 Ångström. Silver (Ag) was deposited on the first conductive layer CDL1 to form a second conductive layer CDL2, and a thickness of the second conductive layer CDL2 was set to be 100 Ångström. Ytterbium (Yb) was deposited on the second conductive layer CDL2 to form a third conductive layer CDL3, and a thickness of the third conductive layer CDL3 was set to be 10 Ångström. An X-ray diffraction (XRD) analysis was used to analyze a size of the plurality of dense planes of the second driving electrode DE2 and an interplanar distance of the plurality of dense planes of the second driving electrode DE2.

**Table 1**

| | Whether a third conduc tive layer is omitted | Whether a heating process is perfor med | Diffract ion angle (°) | Size of a plurality of dense planes (Å) | full width at half maxim um | Interpl anar distance of a plurality of dense planes (Å) | Density orientation |
|---|---|---|---|---|---|---|---|
| Example 2 | X | O | 19.127 | 57.1 | 1.46 | 2.3510 | 6.13 |
| Manufactured Example 2 | X | X | 19.117 | 56.4 | 1.47 | 2.3521 | 6.53 |
| Exampl e 3 | O | O | 19.159 | 58.9 | 1.41 | 2.3471 | 5.50 |
| Manufactured Example 3 | O | X | 19.138 | 53.1 | 1.56 | 2.3496 | 5.34 |

Referring to Table 1, it is confirmed in Experimental Example 2 of the present disclosure that the size of the plurality of dense planes of Example 2 is greater than a size of the plurality of the plurality of dense planes of Manufactured Example 2, and the interplanar distance of the plurality of dense planes of Example 2 is smaller than the interplanar distance of the plurality of dense planes of Example 2. Accordingly, it is confirmed that performing a heating process improves film quality of the second driving electrode DE2.

In addition, it is confirmed that the size of the plurality of dense planes of Example 3 is greater than the size of the plurality of dense planes of Example 3, and the interplanar distance of the plurality of dense planes of Example 3 is smaller than the interplanar distance of the plurality of dense planes of Example 3. Accordingly, it is confirmed that regardless of a configuration of the second driving electrode DE2, performing a heating process improves film quality of the second driving electrode DE2.

In addition, a crystal structure of Example 2, Example 3, Manufactured Example 2 and Manufactured Example 3 may be a face-centered cubic lattice crystal structure. A plurality of dense planes may be a plurality of crystal planes having Miller Index of (111), and a plurality of non-dense planes may be a plurality of crystal planes having Miller Index of (220). A density orientation in Example 2 and Example 3 may be greater than or equal to 5.40 and smaller than or equal to 6.40. However, a density orientation may be greater than 6.40 in Manufactured Example 2, and smaller than 5.40 in Manufactured Example 3.

### Experimental Example 3

In Experimental Example 3 of the present disclosure, light-emitting efficiency of a light-emitting diode LD was confirmed according to whether a heating process was performed on a first driving electrode DE1 and a light-emitting part LEP. The heating process was performed at 85 °C for 20 minutes. Ytterbium (Yb) was deposited on a light-emitting part LEP to form a first conductive layer CDL1, and a thickness of the first conductive layer CDL1 was set to be 10 Ångström. Silver (Ag) was deposited on the first conductive layer CDL1 to form a second conductive layer CDL2, and a thickness of the second conductive layer CDL2 was set to be 110 Ångström. Ytterbium (Yb) was deposited on the second conductive layer CDL2 to form a third conductive layer CDL3, and a thickness of the third conductive layer CDL3 was set to be 10 Ångström.

**Table 2**

| | Whether a heating process is performed | Light-emitting efficiency |
|---|---|---|
| Example 4 | O | 103% |
| Manufactured Example 4 | X | 100% |

Referring to Table 2, light-emitting efficiency in Experimental Example 3 is set based on Manufactured Example 4. In addition, light-emitting efficiency of Example 4 and Manufactured Example 4 is compared. As a result, it is confirmed that light-emitting efficiency of Example 4 is greater than light-emitting efficiency of Manufactured Example 4. Accordingly, it is confirmed that light-emitting efficiency of a light-emitting diode LD is improved by performing a heating process.

A display device according to one embodiment may be applicable to various electronic devices. An electronic device according to one embodiment of the present disclosure may include the described display device and further include a module or a device having an additional function other than the display device.

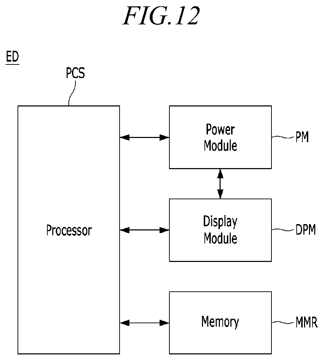

FIG. 12 is a block diagram of an electronic device according to one embodiment of the present disclosure.

Referring to FIG. 12, an electronic device ED according to one embodiment may include a display module DPM, a processor PCS, a memory MMR, and a power module PM.

The processor PCS may include at least one of a central processing unit (CPU), an application processor (AP), a graphic processing unit (GPU), a communication processor (CP), an image signal processor (ISP), and a controller.

Data information for operation of the processor PCS and the display module DPM may be stored in the memory MMR. In the case that the processor PCS initiates an application stored in the memory MMR, an image data signal and/or input control signal is provided to a display module DPM, and the display module may process the provided signal to output image information through a display screen.

The power module PM may include a power supply module, such as a power adaptor or a battery device, and a power conversion module configured to convert power provided from the power supply module to generate power for operation of an electronic device ED.

At least one of each configuration of the described electronic device ED may be included in a display device according to the described embodiments. In addition, some of the separate modules functionally included in one module may be included in a display device, and the other may be provided separately from the display device. For example, the display device may include a display module DPM, and a processor PCS, a memory MMR and a power module PM may be provided in a form of another device in an electronic device ED other than the display device.

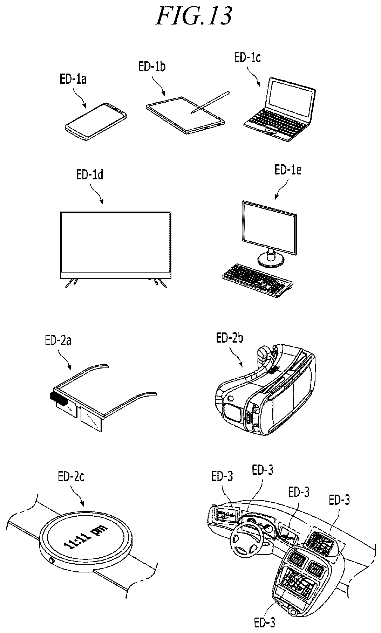

FIG. 13 is an illustration of schematic diagrams of an electronic device according to various embodiments.

Referring to FIG. 13, various electronic devices applied with a display device according to the embodiments may include not only an electronic device for displaying an image, such as a smartphone ED-1a, a tablet PC ED-1b, a laptop ED-1c, a TV ED-1d, and a desk monitor ED-1e, but also a wearable electronic device including a display module, such as smart glasses ED-2a, a head-mounted display ED-2b, and a smartwatch ED-2c, and an electronic device for a vehicle including a display module, such as a dashboard of an automobile, a center fascia, CID (Center Information Display) disposed on a dashboard, and a room mirror display.

While certain embodiments of the present disclosure have been described above, anyone ordinarily skilled in the art to which the present disclosure pertains shall appreciate that there may be a variety of modifications and permutations of the present disclosure without departing from the technical ideas and scopes of the present disclosure that are defined in the appended claims. Moreover, it shall be appreciated that the disclosed embodiments are not intended to restrict the present disclosure thereto and that every technical idea within the appended claims and their equivalents is interpreted to be included in the scope of the present disclosure.

## Claims

1. A display panel (DP) comprising a light-emitting diode (LD), the light-emitting diode (LD) comprising:
a first driving electrode (DE1);
a light-emitting layer (EML) disposed on the first driving electrode (DE1); and
a second driving electrode (DE2) disposed on the light-emitting layer (EML) and comprising a first conductive layer (CDL1) and a second conductive layer (CDL2) in contact with the first conductive layer (CDL1);
wherein the first conductive layer (CDL1) has a first thickness, and
wherein the second conductive layer (CDL2) comprises silver (Ag), is disposed on the first conductive layer (CDL1), and has a second thickness greater than or equal to 7 times of the first thickness and smaller than or equal to 15 times of the first thickness.

2. The display panel (DP) of claim 1,
wherein the first thickness is greater than or equal to 5 Ångström and smaller than or equal to 20 Ångström, and
wherein the second thickness is greater than or equal to 35 Ångström and smaller than or equal to 300 Ångström.

3. The display panel (DP) of claim 2,
wherein a size of crystal plane having Miller Index of (111) on the second driving electrode (DE2) is greater than or equal to 54 Ångström and smaller than or equal to 64 Ångström.

4. The display panel (DP) of claim 2 or claim 3,
wherein an interplanar distance among a plurality of crystal planes having Miller Index of (111) on the second driving electrode (DE2) is greater than or equal to 2.345 Ångström and smaller than or equal to 2.349 Ångström.

5. The display panel (DP) of any one of claims 2 to 4,
wherein the first conductive layer (CDL1) comprises at least one of ytterbium (Yb), nickel (Ni), copper (Cu), aluminium (Al), gold (Au) and lithium fluoride (LiF) and
wherein the second conductive layer (CDL2) further comprises at least one of magnesium (Mg), ytterbium (Yb) and copper (Cu).

6. The display panel (DP) of claim 1,
wherein the second driving electrode (DE2) further comprises a third conductive layer (CDL3) in contact with the second conductive layer (CDL2), and
wherein the third conductive layer (CDL3) is disposed on the second conductive layer (CDL2) and has a third thickness smaller than the second thickness.

7. The display panel (DP) of claim 6,
wherein the first thickness is greater than or equal to 5 Ångström and smaller than or equal to 20 Ångström,
wherein the second thickness is greater than or equal to 35 Ångström and smaller than or equal to 300 Ångström, and
wherein the third thickness is greater than or equal to 5 Ångström and smaller than or equal to 20 Ångström.

8. The display panel (DP) of claim 7,
wherein a size of crystal plane having Miller Index of (111) on the second driving electrode (DE2) is greater than or equal to 56.5 Ångström and smaller than or equal to 67.5 Ångström.

9. The display panel (DP) of claim 7 or claim 8,
wherein an interplanar distance among a plurality of crystal planes having Miller Index of (111) on the second driving electrode (DE2) is greater than or equal to 2.3500 Ångström and smaller than or equal to 2.3520 Ångström.

10. A manufacturing method for a display panel (DP) comprising:
preparing a first driving electrode (DE1) and a light-emitting layer (EML) to be disposed on the first driving electrode (DE1);
heating the first driving electrode (DE1) and the light-emitting layer (EML);
forming a first conductive layer (CDL1) on the heated light-emitting layer (EML); and
forming a second conductive layer (CDL2) directly on the first conductive layer (CDL1) and comprising silver (Ag).

11. The manufacturing method for a display panel (DP) of claim 10,
wherein in the heating of the first driving electrode (DE1) and the light-emitting layer (EML), the first driving electrode (DE1) and the light-emitting layer (EML) are heated to a temperature higher than or equal to 70 °C and lower than or equal to 90 °C.

12. The manufacturing method for a display panel (DP) of claim 11,
wherein in the heating of the first driving electrode (DE1) and the light-emitting layer (EML), the first driving electrode (DE1) and the light-emitting layer (EML) are heated for a time longer than or equal to 20 minutes or shorter than or equal to 30 minutes.

13. The manufacturing method for a display panel (DP) of claim 12,
wherein in the heating of the first driving electrode (DE1) and the light-emitting layer (EML), the first driving electrode (DE1) and the light-emitting layer (EML) are heated under a vacuum environment.

14. The manufacturing method for a display panel (DP) of claim 12 or claim 13,
wherein in the forming of the first conductive layer (CDL1), a temperature of the light-emitting layer (EML) is higher than or equal to 60 °C and lower than or equal to 90 °C.

15. The manufacturing method for a display panel (DP) of any one of claims 10 to 14,
wherein in the forming of the second conductive layer (CDL2), a first deposition material and a second deposition material are simultaneously deposited, the first deposition material is silver (Ag), and the second deposition material comprises any of magnesium (Mg), ytterbium (Yb) and copper (Cu).
